(19) Europäisches Patentamt
European Patent Office
Office européen des brevets

(11) **EP 4 513 370 A1**

(12) **EUROPEAN PATENT APPLICATION**

(43) Date of publication:
**26.02.2025  Bulletin 2025/09**

(21) Application number: **23193356.5**

(22) Date of filing: **25.08.2023**

(51) International Patent Classification (IPC):
**G06F 30/15** (2020.01)  **B65G 54/02** (2006.01)
**G06F 30/20** (2020.01)  **B65G 23/23** (2006.01)

(52) Cooperative Patent Classification (CPC):
**G06F 30/15;** B65G 54/02; G06F 30/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Robert Bosch GmbH**
**70442 Stuttgart (DE)**

(72) Inventors:
• **Aarden, Walter**
  **5507 TB Eindhoven (NL)**
• **Tielen, Niels**
  **4871 LM Etten-Leur (NL)**

(54) **METHOD FOR DETERMINING A GEOMETRY OF TRACK MODULES FOR A LINEAR MOTOR CONVEYING SYSTEM, METHOD FOR MANUFACTURING TRACK MODULES AND CORRESPONDING SYSTEMS**

(57)    A computer-implemented method for determining a geometry of track modules for a linear motor conveying system, wherein a trajectory is defined by conveying paths, wherein the trajectory comprises a starting point (P1) and an end point (P2), and wherein the trajectory is, at least in part, curved, wherein the method comprises: providing boundary conditions, comprising pre-defined limits physical parameters, and a pre-defined angle ($\theta$) of the trajectory between the starting point and the end point, wherein said physical parameters are related to a movement of the carrier module when being conveyed within said one track module or within said multiple track modules when connected to each other, and/or to a shape of the trajectory; determining, based on the boundary conditions, a function of a carrier angle ($\varphi$) over time, when the carrier module is conveyed, wherein the carrier angle is an angle between a current moving direction of the carrier module with respect to a moving direction (R) when entering said trajectory at the starting point (P1); determining, based on the function of the carrier angle, the shape of at least part of the trajectory; determining, based on the shape of the at least part of the trajectory, the geometry of said one or each of said multiple track modules; and providing information about the geometry of said one or each of said multiple track modules.

**Fig. 4a**

**Description**

The present invention relates to a method for determining a geometry of one or multiple track modules for a linear motor conveying system, to a method for manufacturing one or more track modules, to a system comprising one or more track modules and to a linear motor conveying system.

Background of the invention

Linear conveying systems like linear motor conveying systems can be used in different applications, e.g., industrial applications. For example, linear motor conveying systems can be used in the field of high-speed conveyance solutions for in-machine and inter-machine transportation. Such solutions can be inverted linear motor systems, which can control small workpiece carriers accurately and with high dynamics. The carriers themselves can be passive.

Disclosure of the invention

According to the invention, a method for determining a geometry of one or multiple track modules, a method for manufacturing one or more track modules, a system comprising one or more track modules and a linear motor conveying system with the features of the independent claims are proposed. Advantageous embodiments are subject-matter of dependent claims and of the following description.

The invention relates to linear motor conveying systems and the track modules used therein. Such a linear motor conveying system comprises one or more track modules and one or more carrier modules (or carriers) to be guided in the one or more track modules. The track modules can be standardized modules, several of such modules can be connected to each other to form a track system. A track module, for example, has or defines at least one conveying path, i.e., a path along which the carrier modules are to be guided and moved. Such track modules can be of different types, e.g., straight modules, curve modules, and switch modules. Such different modules in required numbers can be connected to from a track system according to specific needs. While a straight modules and curve modules typically have one conveying path, a switch module can have at least two conveying paths, or one conveying path split into two conveying paths.

The present invention particular relates to track modules having a curved track geometry, i.e., track modules in which at least part of the track to guide the carrier is curved and not straight. Such track modules are, in particular, curve modules and switch modules (switch modules can have straight and curved track parts, for example).

A general problem which needs to be solved is apparent in the curve and switch modules. Within these modules, the carrier module needs to follow a curved path. When moving a carrier module through a curve (i.e. any trajectory which is not straight) there will be additional accelerations and jerks acting upon the carrier module, for example. These accelerations and jerks will have an impact on a maximum payload and velocity the carrier module can carry and transport through the curve, as well as the lifetime of rollers and rails (i.e. the guidance system).

It has turned out that these accelerations, jerks and the negative effects which follow from them, can be reduced by optimizing the design of the curved trajectory. A method in the field of high-speed conveyance can be using a clothoid. This is a mathematical model where the curve changes linearly with the curve length. Mirroring the shape obtained with the model will result in the curved trajectory. Another method can be to divide the curve in segments and optimize different modified splines for each curve segment.

An embodiment of the present invention relates to a computer-implemented method for obtaining or defining a geometry of one or multiple track modules, which provide a curved trajectory. This method allows calculating (or determining) the curved trajectory in such a way that it optimizes the trajectory of the carrier module and minimizes negative effects, while at the same time providing clear advantages over currently used methods.

The method allows determining the geometry of single (curved) track module or of multiple tracked track modules to be connected to each other (which are then curved, in total). Said one or each of said multiple track modules comprises a conveying path and is configured to receive a carrier module, the carrier module to be conveyed within said one track module or within said multiple track modules when connected to each other, along a trajectory. The trajectory is defined by the conveying path or the conveying paths being connected to each other, wherein the trajectory comprises a starting point and an end point, and wherein the trajectory is, at least in part, curved. Note that in this way it does not matter whether a certain trajectory is defined by one or multiple tracking modules to be connected to each other. Depending on the specific manufacturing process, several shorter track modules can be manufactured or a single longer one.

The method compromises providing boundary conditions. The boundary conditions comprise pre-defined limits (e.g., upper and/or lower limits or a range) of one or more physical parameters. Said one or more physical parameters are related to a movement of the carrier module when being conveyed within said one track module or within said multiple track modules when connected to each other, and/or to a shape of the trajectory.

For example, said one or more physical parameters comprise and/or are based on at least one of the following physical parameters: a centrifugal force acting on the carrier module when conveyed, a change of the centrifugal force acting on the carrier module when conveyed, an angular acceleration acting on the carrier module when conveyed, a change of the angular acceleration acting on the carrier module when conveyed, a jerk acting on the carrier module when conveyed, a change of the jerk acting on the carrier module when conveyed, a velocity (can be an angular velocity or a standard velocity) of the carrier module when conveyed, a change of the velocity of the carrier module when conveyed, a payload to be carried by the carrier module when conveyed, and a distance between the starting point and the end point of the trajectory. It is noted that some of these physical parameters relate to each other or depend on each other and it might be sufficient to only defined limits for only some of them. Further, not all of these physical parameters need to be used to define boundary conditions. For example, the centrifugal force might be limited to 250 N in order to ensure a certain lifetime of the track modules. This maximum force in turns limits the maximum angular acceleration of the carrier. At least part of these physical parameters or the respective boundary conditions can be measured or based on measurements, for example.

For example, the distance between the starting point and the end point of the trajectory can be a fixed value, defined by external requirements where the track modules are to be used; e.g., the application of the final linear motor conveying system can require specific values. In this case, a specific value for the distance between the starting point and the end point of the trajectory can be a boundary condition (in this case, the limit defines a specific value). Also, the distance between the starting point and the end point of the trajectory might be used as tuning parameter as will be described later.

The boundary conditions can further comprise that the trajectory is to be entered by the carrier module, at the starting point, in a straight movement, and/or that the trajectory is to be left by the carrier module, at the end point, in a straight movement.

Further, the boundary conditions comprise a pre-defined angle of the trajectory between the starting point and the end point. This pre-defined angle can be between 170° and 190°, preferably, 180°. In other words, the trajectory can correspond to a (full) U-turn, for example.

Based on the boundary conditions, a function of a carrier angle over time, when the carrier module is conveyed, is determined. The carrier angle is an angle between a current moving direction of the carrier module with respect to a moving direction when entering said trajectory at the starting point. This, in turn, can comprise, for example, determining, based on the boundary conditions, a function of a carrier angular acceleration over time, when the carrier module is conveyed, determining, based on the function of a carrier angular acceleration over time, a function of a carrier angular velocity over time, when the carrier module is conveyed; and determining, based on the function of a carrier angular velocity over time, the function of the carrier angle over time.

Further, based on the function of the carrier angle, the shape of at least part of the trajectory is determined. This can include determined the shape of the entire trajectory. Based on the shape of the at least part of the trajectory, the geometry of said one or each of said multiple track modules is determined. Since the track modules defined the trajectory, the final geometry of the track modules can easily be determined from the trajectory, e.g. considering a width of a conveying path with the trajectory, e.g., defined in the middle thereof.

Further, information about the geometry of said one or each of said multiple track modules is then provided, e.g., for manufacturing said one or multiple track modules. Using the such method for determining the geometry allows a faster and determination of the geometry and, thus, a faster manufacturing. Further, such method allows a more exact and smooth geometry, which, in turn, improves operation of the linear motor conveying system.

In an embodiment, the shape of the trajectory is determined, based on the function of the carrier angle, within an optimization. In such optimization, a tuning parameter can comprise the distance between the starting point and the end point of the trajectory, as mentioned earlier.

Using this method, the actual shape of the curve is, preferably, as follows. The radius of the curve (trajectory) slowly and smoothly decreases to a minimum at the middle of a curve (where the carrier angle is equal to -90°, for example). Correspondingly, the curvature of the curve increases. Then the curve radius slowly and smoothly increases until it is again straight. minimum at the middle of a curve (where the carrier angle is equal to -90°, for example). Correspondingly, the curvature of the curve decreases.

In an embodiment, the trajectory comprises at least two segments, preferably, at least three segments, connected to each other. The boundary conditions then further comprise a pre-defined shape (e.g., a constant or otherwise particularly changing radius) of one of said at least two segments, e.g., a middle one of three segments. In this way, part of the trajectory can be pre-defined with the remaining part being optimized as mentioned above. The constant radius, for example, results in a constant angular velocity and, thus, zero angular acceleration along the respective segment. This can be considered for the boundary conditions. A transition to and from the constant radius segment is, preferably, smooth and continuous.

A high-order Fourier series (which is continuous by definition), for example, can be fit to the carrier angle. Using the Fourier estimation, a curve can be designed using a single generator (i.e. the Fourier series estimation) which is also optimized for the same boundary conditions as the above-mentioned method (i.e. forces on the guidance). Furthermore, it very closely resembles the desired shape of the curve, so a smooth transition with a defined segment which has a constant radius can be achieved.

Another embodiment of the invention relates to a method of manufacturing one or multiple track modules, based on information about a geometry of said one or each of said multiple track modules. Said information about the geometry is obtained by means the method in one of the embodiments mentioned above.

Another embodiment of the invention relates to system comprising one or multiple track modules, wherein said one or each of said multiple track modules comprises a conveying path and is configured to receive a carrier module, the carrier module to be conveyed within said one track module or within said multiple track modules when connected to each other, along a trajectory. The trajectory is defined by the conveying path or the conveying paths being connected to each other, wherein the trajectory comprises a starting point and an end point, and wherein the trajectory is, at least in part, curved. A curvature of the trajectory, from the starting point to the end point, continuously increases until an intermediate point and then continuously decreases from that intermediate point or another intermediate point. Between two such intermediate points, the mentioned segment for the trajectory with predefined shape can be present. As mentioned above, such particular shape of a trajectory can be obtained by the method described above.

Another embodiment of the invention relates to a linear motor conveying system, comprising the system having the one or multiple track modules, and one or more carrier modules to be guided in the one or more track modules. The one or each of the more carrier modules is received or receivable in the one or each of the more track modules. The linear motor conveying system can further comprise a controlling system for controlling the linear motor conveying system to move the one or each of the more carrier modules within the one or more track modules

Further advantages and embodiments of the invention result from the description and the attached drawing.

It goes without saying that the features mentioned above and those still to be explained below can be used not only in the combination specified in each case, but also in other combinations or on their own, without departing from the scope of the present invention.

The invention is shown schematically in the drawing using an exemplary embodiment and is described in detail below with reference to the drawing.

Brief description of the drawing

Fig. 1      shows a linear motor conveying system according to an embodiment in a perspective view;

Fig. 2      shows a track module according to an embodiment in a perspective view;

Fig. 3a      shows a track module and a carrier module according to an embodiment in a perspective view;

Fig. 3b      shows the track module and the carrier module of Fig. 3a in a cross section;

Fig. 3c      shows the carrier module of Fig. 3a in a perspective view;

Fig. 4a      shows a trajectory according to an embodiment;

Fig. 4b      shows a trajectory according to a further embodiment;

Fig. 5a      shows diagrams for illustrating a method according to an embodiment;

Fig. 5b      shows diagrams for illustrating a method according to another embodiment; and

Fig. 6      shows a method according to an embodiment.

Detailed description of the drawing

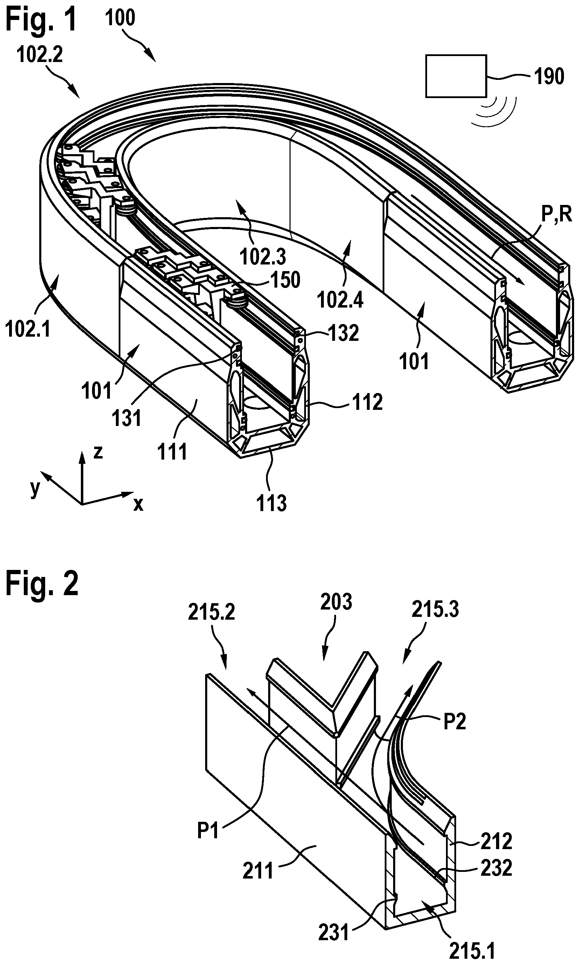

Fig. 1 schematically illustrates a linear motor conveying system 100 according to an embodiment in a perspective view. The linear motor conveying system 100 comprises, by means of example, several track modules. Depending on the needs of a particular application for the linear motor conveying system, different types and numbers of track modules can be provided and also connected to each other to provide a track system. Types of track modules are, for example, straight modules, curve modules and switch modules.

By means of example, two track modules 101 are straight modules, and four track modules 102.1, 102.2, 102.3, 102.4 are curve modules. The straight modules 101 are both identical, in the example shown in Fig. 1. It is noted, however, that straight modules can have a different length, where a length is to be seen in moving or conveying direction along a conveying path P, indicated for a straight module 101 in Fig. 1.

The curve modules 102.1, 102.2, 102.3, 102.4 are different from each other, in the example shown in Fig. 1. The curve modules 102.1, 102.2, 102.3, 102.4 have different radii and/or curve shapes, for example. It is noted, however, that these four different curve modules are only for illustration. According to needs, different curve modules having different radii and/or different shape can be provided. However, the curve modules have in common that they all provide curved tracks, in particular, only curved tracks.

The straight module 101 at the lower left side in Fig. 1 will be described in more detail. The track module 101 comprises a track component 110, and at least two bearing surfaces 131, 132. By means of example, six bearing surfaces are shown in Fig. 1, while only two of them are indicated with a reference numeral.

Further, the track component 110 comprises a first side part 111, a second side part 112 and a bottom part 113, wherein the first side part 111 and the second side part 113 are arranged opposite to each other. By means of example, the track component 110, and also each of the first side part 111, the second side part 112 and the bottom part 113, are formed to have a structure with struts or ribs, rather than a full material structure. This allows using less material while still having a robust structure.

At least a first one of the at least two bearing surfaces (here, e.g., bearing surface 131) is arranged at or formed integrally with the first side part 111, and at least a second one of the at least two bearing surfaces (here, e.g., bearing surface 132) is arranged at or formed integrally with the second side part 112, such that the at least one first bearing surface 131 and the at least one second bearing surface 132 face each other.

By means of example, the bearing surfaces are formed by support structures like rods, arranged in or inserted into recesses in the first side part 111 and the second side part 112. In general, however, such bearing surface can also be formed by the first side part 111 and the second side part 112, e.g., by having specific shapes.

It is noted that this way of how a track module is formed, does not only apply to straight module 101 but also to other types of modules like the curve modules 102.1, 102.2, 102.3, 102.4.

Each of the straight modules and the curve modules shown in Fig. 1, have a conveying path, although only shown for one straight module 101, from a respective first to a respective second end. When the track modules are connected to each other, the individual tracking paths are also connected to form a cumulated conveying path, along which the carrier modules are guided and conveyed. Note that carrier modules can be moved or conveyed in both directions of a conveying path, irrespective of the direction of the arrow indicating the conveying path P.

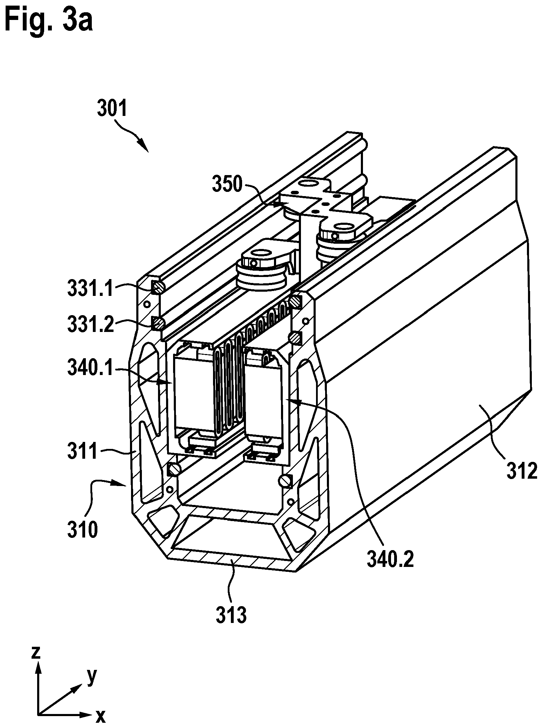

Further, the linear motor conveying system 100 comprises, by means of example, several carrier modules 150 (six carrier modules are shown in Fig. 1, while only one of them is indicated with a reference numeral). The track module 101 is configured to receive such a carrier module 150 between the first side part 111 and the second side part 112, in particular, such that the at least one first bearing surface 131 matches with at least a first wheel of the carrier module 150, and that the at least one second bearing surface 132 matches with at least a second wheel of the carrier module 150. This is shown in Fig. 1 but will be illustrated and described in more detail later with respect to Figs. 3a to 3c.

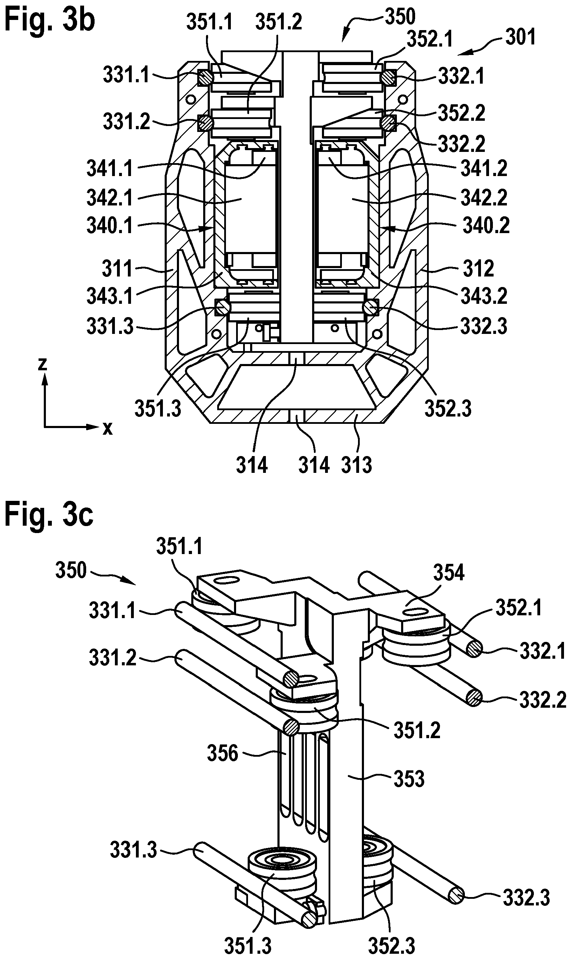

Further, the linear motor conveying system 100 comprises, in an embodiment, a controlling system 190 for controlling the linear motor conveying system 100 to move the carrier modules 150 within the track modules 101, 102.1, 102.2, 102.3, 102.4, i.e., in moving or conveying direction R, indicated in Fig. 1. It is noted that such conveying direction R is a straight line for straight modules, but it is a curved line for curved modules. For operating the linear motor conveying system 100, by means of the controlling system 190, electro-magnetic motor components, for example, at the track modules, have to be controlled. Such electro-magnetic motor components are not shown in Fig. 1 but will be shown in Figs. 3a, 3b.

Fig. 2 schematically illustrates a track module 203 according to an embodiment in a perspective view. Track module 203 is a switch module, i.e., a track module of the switch type. Contrary to straight modules or curve modules, the carrier module is not restricted to move from one of two ends to the other of the two ends, i.e., enter the track module at a first end and leave the track module at a second end (having a single conveying path). Rather, the carrier module can enter the switch module at a first end 215.1 and leave the switch module at either a second end 215.3 or at a third end 215.3. The switch module 203 has two conveying paths P1 and P2, where conveying path P2 diverts from conveying path P1.

In order to control a linear motor conveying system comprising such switch module, in order to make the carrier module using conveying path P1, leaving at the second end 215.2 or using conveying path P2, leaving at the third end 215.3, electro-magnetic motor components, for example, at the track modules (not shown here), are to be controlled such that the carrier module is forced either to the second end 215.2 or to the third end 215.3. If the carrier module enters the switch module at the second end 215.2 or at the third end 215.3, in both cases, the carrier module with leave the switch module 203 at the first end 215.3. In other words, both conveying paths P1, P2 are merged.

Similar to the straight modules and curve modules shown in Fig.1, the switch module 203 comprises a track component 210 for a conveying path, e.g., P1. The switch module 203 further comprises at least two bearing surfaces 231, 232. By means of example, six bearing surfaces are shown in Fig. 2, while only two of them are indicated with a reference numeral.

Further, the track component 210 comprises, along the conveying path P1, a first side part 211, a second side part 212 and a bottom part 213, wherein the first side part 211 and the second side part 213 are arranged opposite to each other. It is noted that the second side part 211 is interrupted along the conveying path P1, due to a diversion of conveying path P2. Similar to the conveying path P1, the track component comprises, along the conveying path P2, a first side part, a second side part and a bottom part (not indicated with reference numerals here).

By means of example, the track component 210, and also each of the first side part 211, the second side part 212 and the bottom part 113, are formed to have a full material structure, different to the track modules shown in Fig. 1. Depending on the way how the bearing surfaces are formed, e.g., their inclination, wheels of the carrier modules might have to have a corresponding inclination or arrangement.

At least a first one of the at least two bearing surfaces (here, e.g., bearing surface 231) is arranged at or formed integrally with the first side part 211, and at least a second one of the at least two bearing surfaces (here, e.g., bearing surface 232) is arranged at or formed integrally with the second side part 212, such that the at least one first bearing surface 231 and the at least one second bearing surface 232 face each other.

By means of example, and different to the bearing surfaces shown in Fig. 1, the bearing surfaces are formed by the first side part 211 and the second side part 212, by having specific shapes or geometry. Such switch module, however, could also comprise earing surfaces formed like for the track modules shown in Fig. 1. Also, such switch module could comprise a track component formed like for the track modules shown in Fig. 1, i.e. with struts or rib structure.

Switch modules like the one shown in Fig. 2, can be used together with straight modules and curve modules like the one shown in Fig. 1, in order to create a (complex) track system and linear motor conveying system. It should be considered, that the bearing surfaces of the different track modules should be of the same type

Fig. 3a illustrates a track module 301 and a carrier module 350 according to an embodiment in a perspective view. Fig. 3 b illustrates the track module 301 and the carrier module 350 of Fig. 3a in a cross section in the x-y-plane. Fig. 3c illustrates the carrier module 350 of Fig. 3a in a perspective view but without most parts of the track module. Figs. 3a, 3b, 3c shall be described together in the following.

By means of example and for explanation of the basic structure and composition of a track module, track module 301 is a straight module. Track module 301 can correspond to track module 101 of Fig. 1, however, showing additional components. The following explanations apply also to other types of track modules.

The track module 301 comprises a track component 310, and, by means of example, six bearing surfaces 331.1, 331.2, 331.3, 332.1, 332.2, 332.3. Further, the track component 301 comprises, along a conveying path, a first side part 311, a second side part 312 and a bottom part 313, wherein the first side part 311 and the second side part 313 are arranged opposite to each other. The conveying path is not denoted in Fig. 3, but extends along the y-direction and can be similar or equal to conveying path P shown in Fig. 1.

By means of example, the track component 310, and also each of the first side part 311, the second side part 312 and the bottom part 313, are formed to have a structure with struts or ribs, rather than a full material structure. This allows using less material while still having a robust structure. For example, the bottom part 313 and parts of each of the first side part 311 and the second side part 312 have a double wall structure with supporting ribs between the two walls.

Three first bearing surfaces (here, e.g., bearing surfaces 331.1, 331.2, 331.3) are arranged at or formed integrally with the first side part 311, and three second bearing surfaces (here, e.g., bearing surfaces 332.1, 332.2, 332.3) are arranged at or formed integrally with the second side part 312, such that the at first bearing surfaces 331.1, 331.2, 331.3 and the second bearing surfaces 332.1, 332.2, 332.3 face each other, i.e., are oriented towards each other. In other words, all of the bearing surfaces are provided at an inner side of the respective first and second side parts, where the conveying path is formed.

By means of example, the bearing surfaces are formed by support structures like rods, arranged in or inserted into recesses in the first side part 311 and the second side part 312. In general, however, such bearing surface can also be formed by the first side part 311 and the second side part 312, e.g., by having specific shapes.

In an embodiment, the track 301 further comprises two electro-magnetic motor components, a first electro-magnetic motor component 340.1 and a second electro-magnetic motor component 340.2. The first electro-magnetic motor component 340.1 and the second electro-magnetic motor component 340.2 extend along the conveying path (here: in y-direction). The first electro-magnetic motor component 340.1 is arranged at the first side part 311, and the second electro-magnetic motor component 340.2 is arranged at the second side part 312, such that the first electro-magnetic motor component 340.1 and the second electro-magnetic motor 340.2 component face each other.

In an embodiment, the first electro-magnetic motor component 340.1 comprises one or more electric coils 341.1; a number of the electric coils can depend on the way how the coils are manufactured. Further, the first electro-magnetic motor component 340.1 can comprise one or more magnetic or ferromagnetic cores or a structured magnetic core 342.1, e.g., made of iron. Such magnetic or ferromagnetic core increases the magnetic forces produced by the electric coils. Further, the first electro-magnetic motor component 340.1 can comprise a holding or fixing structure 343.1 for fixing the coils and magnetic core to the first side part 311. The first electro-magnetic motor component 340.1 can be fixed to the first side part 311 by means of gluing and/or screwing, for example.

Similarly, the second electro-magnetic motor component 340.2 comprises one or more electric coils 341.2; a number of the electric coils can depend on the way how the coils are manufactured. Further, the second electro-magnetic motor component 340.2 can comprise one or more magnetic or ferromagnetic cores or a structured magnetic core 342.2, e.g., made of iron. Such magnetic or ferromagnetic core increases the magnetic forces produced by the electric coils. Further, the second electro-magnetic motor component 340.2 can comprise a holding or fixing structure 343.2 for fixing the coils and magnetic core to the second side part 312. The second electro-magnetic motor component 340.2 can be fixed to the second side part 312 by means of gluing and/or screwing, for example.

In an embodiment, the bottom part 313 is configured to be placed on and/or to be oriented towards and/or to be mounted to a ground surface. Such ground surface would be below the bottom part 313, seen in z-direction in Figs. 3a, 3b. In an embodiment, the bottom part 313 comprises one or more holes 314 facing the ground surface. This allows for cleaning out small piece of debris. Also, any fluid, e.g., water, is allowed to drain when used in an IP65 type of environment, for example.

The track module 301 is configured to receive a carrier module 350 between the first side part 311 and the second side part 312 and is, preferably, configured such that the first bearing surfaces 332.1, 332.2, 332.3 match with respective first wheels of the carrier module 350, and that the second bearing surfaces 332.1, 332.2, 332.3 match with respective second wheels of the carrier module 350.

While Figs. 3a, 3b shown the carrier module 350 being received in the track module 301, Fig. 3c shows the carrier module 350 as such. In addition, Fig. 3c shows the six bearing surfaces 331.1, 331.2, 331.3, 332.1, 332.2, 332.3 (these are rods, in this example). The carrier module 350 comprises a carrier component 353 and, by means of example, six wheels, three first wheels 351.1, 351.2, 351.3, and three second wheels 352.1, 352.2, 352.3 (note that wheel 352.2 is not visible in Fig. 3c). The carrier module 350 is configured to be received between the first side part 311 and the second side part 312 of the track module 301.

By means of example, three first wheels 351.1, 351.2, 351.3 and the three second wheels 352.1, 352.2, 352.3 are arranged at the carrier component 353 opposite to each other, such that three first wheels 351.1, 351.2, 351.3 face the first side component 311 and the three second wheels 352.1, 352.2, 352.3 face the second side component 312, when received in the track module 301. This can be seen in Figs. 3a, 3b. Each of the wheels 351.1, 351.2, 351.3, 352.1, 352.2, 352.3 matches with a respective one of the six bearing surfaces 331.1, 331.2, 331.3, 332.1, 332.2, 332.3. This can be seen in Fig. 3c. With respect to the bearing surface and the wheels, matching means that a wheel can be guided by and roll on a respective bearing surface. A bearing surface could, thus, also be called a rolling surface. The wheels, for example, can comprise a groove matching with the bearing surface.

In an embodiment, the carrier module 350 further comprises two counterpart electro-magnetic motor components, a first counterpart electro-magnetic motor component 356 (shown in Fig. 3c) and a second counterpart electro-magnetic motor component (not visible in Fig. 3c). Each of such counterpart electro-magnetic motor component can comprise one or more permanent magnets, for example. The first counterpart electro-magnetic motor component 356 and the second counterpart electro-magnetic motor component 356 are arranged at the carrier component 353 opposite to each other, such that the first counterpart electro-magnetic motor component 356 faces the first electro-magnetic motor component 340.1 of the track module 301 and that the second counterpart electro-magnetic motor component faces the second electro-magnetic motor component 340.2 of the track module 301, when received in the track module 301. This can be seen in Fig. 3a.

The first counterpart electro-magnetic motor component 356 matches with the first electro-magnetic motor component 340.1, i.e., these two components electro-magnetically interact with each other in order to from a linear electro-magnetic motor. This also, typically, requires an air gap of appropriate size between these two components. Similarly, the second counterpart electro-magnetic motor component matches with the second electro-magnetic motor component 340.2, i.e., these two components electro-magnetically interact with each other in order to from a linear electro-magnetic motor. This also, typically, requires an air gap of appropriate size between these two components. Thus, the track module 301 allows receiving a state of levitation of the carrier module 350 between the two side parts of the track module 301; this reduces cogging.

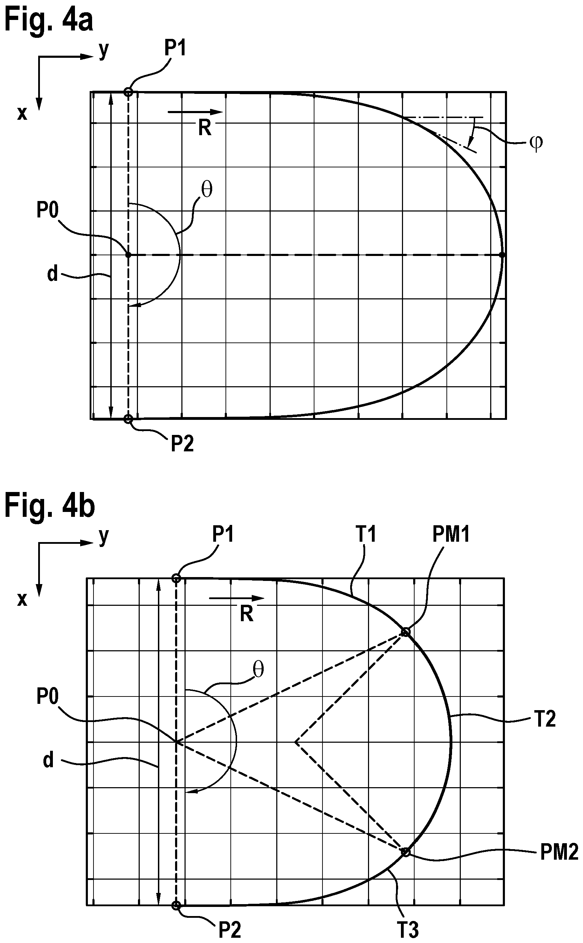

Fig. 4a schematically illustrates a trajectory T obtained or determined by means of a method according to an embodiment. As explained with respect to Fig. 1, track modules comprise a conveying path. The conveying path of one track module or the conveying paths of multiple track modules being connected to each other, can define a trajectory. For example, the four curve modules 102.1, 102.2, 102.3, 102.4 shown in Fig. 1, each comprise a conveying path and, connected to each other, can form a trajectory like the trajectory T shown in Fig. 4a.

The trajectory T comprises a starting point P1 and an end point P2. These points are those where a straight tracking module ends or begins, see Fig. 1. An angle θ between the starting point P1 and the end point P2 can be defined as shown in Fig. 4a, e.g., via point or origin P0. In the example shown, this angle θ is 180° and can be used as a boundary condition. A distance d between starting point P1 and the end point P2 is also illustrated in Fig. 4a.

Further, a carrier angle φ is an angle between a current moving direction of the carrier module with respect to a moving direction when entering said trajectory T at the starting point P1. A moving direction in general is denoted R. In the situation shown in Fig. 4a, the moving direction when entering said trajectory at the starting point P1 is along the y axis. In other words, the carrier angle φ ca be defined as the angle between the y-axis and the tangent of the curve (or trajectory). This angle is similar to how the carrier "rotates" while moving through a curve. Note that the selection of the y-axis is, as such arbitrarily and could be different.

As mentioned the way the carrier angle changes over time is defined (or limited) by several boundary conditions. These boundary conditions are defined via limits for physical parameters, for example, by the maximum centrifugal force and change of centrifugal force, and/or given by the required lifetime of the guidance system. For example, the maximum allowed centrifugal force is defined at 250 N. This maximum force in turn limits the maximum angular acceleration of the carrier module. Another boundary condition (which can also be a "tuning" parameter) is, for example, the distance d (corresponding to a x pitch here); this distance can also be defined via a radius of the curve. This distance (or x pitch) can be designed to be as small as possible as it will result in the smallest footprint of the curve.

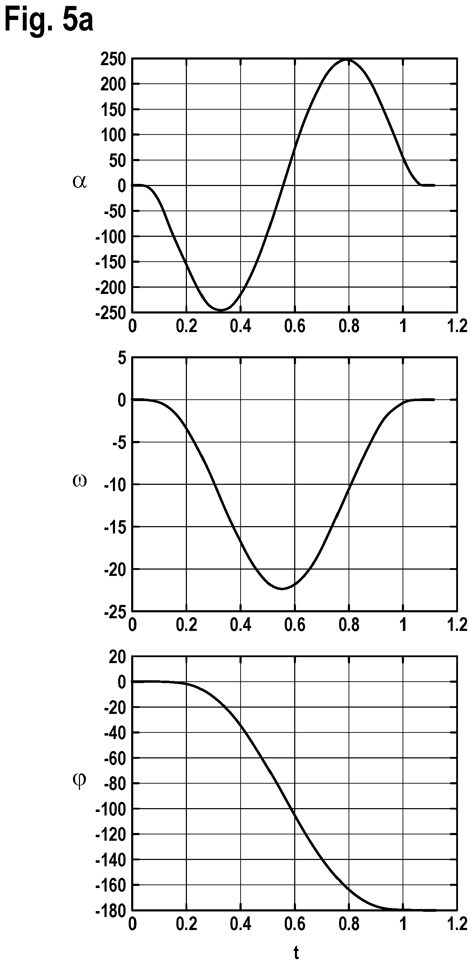

Given these boundary conditions, a relation between the angular acceleration a (in rad/s$^2$) vs. time t (in s) can be defined, and subsequently the angular velocity $\omega$ (in rad/s) vs. time t (in s) and carrier angle $\varphi$ (in rad) vs. time t (s) can be derived through integration. In other words, a function of the carrier angle over time is determined. These three relations are illustrated in the diagrams in Fig. 5a.

In a further step, the x and y coordinates can be determined from the carrier angle. For this, the following

$$y = \int_0^L \cos(\varphi(s))ds$$

formulas can be used.                    and

$$x = \int_0^L \sin(\varphi(s))ds,$$

where $\varphi(s)$ is the angle carrier angle and *L* is the length or arc length of the curve, i.e., the absolute distance the carrier has to travel.

In this way, the trajectory and, thus, also the geometry of the one or multiple multiple track modules can be determined.

Using this method, the actual shape of the curve can be as follows. The radius of the curve slowly and smoothly decreases to a minimum at the middle of the curve or trajectory (where the carrier angle is equal to -90°). Then the curve radius slowly and smoothly increases until it is again straight.

Fig. 4b schematically illustrates a trajectory obtained or determined by means of a method according to another embodiment. The trajectory of Fig. 4b is, basically, similar to that of Fig. 4a. However, the trajectory comprises, by means of example, three segments T1, T2, T3 connected to each other. The segment T2 comprises a pre-defined shape, preferably, a constant radius; this can be used or provided as a further boundary condition.

In this method of deriving the trajectory, generating the x, y positions of the curve (trajectory) are the same as described in the method above. The above method described a curve where the radius changes through the entirety of the curve. However, in this method a custom designed curve can be obtained, which has a defined part of the curve or trajectory (the segment T2) which has a constant radius.

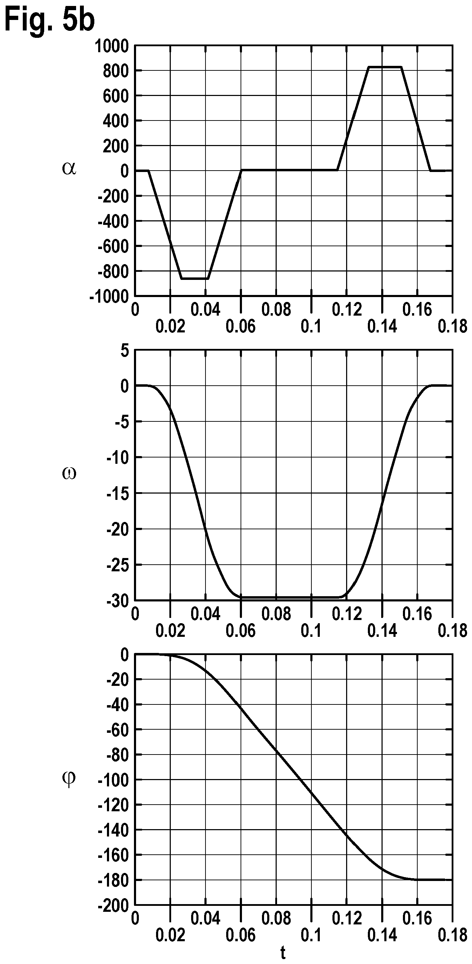

However, a continuous function for the carrier angle over the arc length cannot be defined due to the constant radius section in the center of the curve. This constant radius section is added as a boundary condition (as due to the fact that the radius is constant), it implies that the angular velocity is constant (and angular acceleration is zero). This results in a non-constant relation between angular acceleration, angular velocity and angle vs. time, as illustrate in the diagrams of Fig. 5b.

However, fitting a high-order Fourier series (which is continuous by definition) to the carrier angle is possible. Using the Fourier estimation, a curve can be designed using a single generator (i.e. the Fourier series estimation) which is also optimized for the same boundary conditions as the first method (i.e. forces on the guidance). Furthermore, it very closely resembles the desired shape of the curve, so a smooth transition with a defined section which has a constant radius.

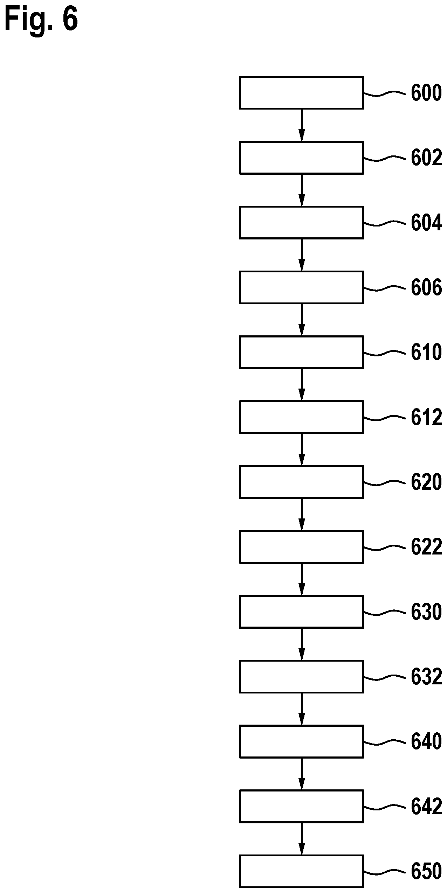

Fig. 6 schematically illustrates a method for determining a geometry of one or multiple track modules according to an embodiment of the invention. In the following, such method will be briefly described with reference to the detailed explanation provided for Figs. 4a, 4b, 5a, 5b.

In step 600, boundary conditions 602 are provided. These boundary conditions comprise pre-defined limits 604 of one or more physical parameters 606, and a pre-defined angle of the trajectory between the starting point and the end point. Examples for such boundary conditions have been explained with respect to Figs. 4a, 4b.

In step 610, a function 612 of a carrier angle over time, when the carrier module is conveyed, is determined. The carrier angle is an angle between a current moving direction of the carrier module with respect to a moving direction when entering said trajectory at the starting point. Examples for such determination have been explained with respect to Figs. 4a, 4b and Figs. 5a, 5b.

In step 620, the shape 622 of at least part of the trajectory is determined. Depending on the embodiment, this can comprise determining the shape of the entire trajectory as explained with respect to Figs. 4a, 5a, or determining the shape of the parts of the trajectory as explained with respect to Figs. 4b, 5b.

In step 630, the geometry 632 of said one or each of said multiple track modules is determined. In step 640 information 642 about the geometry of said one or each of said multiple track modules is provided. Further, in a step 650, one or multiple track modules can be manufactured, based on said information 642 about the geometry of said one or each of said multiple track modules.

## Claims

1.   A computer-implemented method for determining a geometry of one or multiple track modules (102.1, 102.2, 102.3, 102.4) for a linear motor conveying system (100), said multiple track modules to be connected to each other,

wherein said one or each of said multiple track modules comprises a conveying path (P) and is configured to receive a carrier module (150, 350), the carrier module (150, 350) to be conveyed within said one track module or within said multiple track modules when connected to each other, along a trajectory (T),

wherein the trajectory (T) is defined by the conveying path or the conveying paths being connected to each other, wherein the trajectory comprises a starting point (P1) and an end point (P2), and wherein the trajectory is, at least in part, curved,

wherein the method comprises:

Providing (600) boundary conditions (602), wherein the boundary conditions comprise pre-defined limits (604) of one or more physical parameters (606), and wherein the boundary conditions comprise a pre-defined angle ($\theta$) of the trajectory between the starting point and the end point, wherein said one or more physical parameters are related to a movement of the carrier module (150, 350) when being conveyed within said one track module or within said multiple track modules when connected to each other, and/or to a shape of the trajectory;

Determining (610), based on the boundary conditions, a function (612) of a carrier angle ($\varphi$) over time, when the carrier module is conveyed, wherein the carrier angle is an angle between a current moving direction of the carrier module with respect to a moving direction (R) when entering said trajectory at the starting point (P1);

Determining (620), based on the function of the carrier angle, the shape (622) of at least part of the trajectory;

Determining (630), based on the shape of the at least part of the trajectory, the geometry (632) of said one or each of said multiple track modules; and

Providing (640) information about the geometry (642) of said one or each of said multiple track modules.

2. The method of claim 1, wherein the one or more physical parameters (606) comprise and/or are based on at least one of the following physical parameters:

- a centrifugal force acting on the carrier module when conveyed,
- a change of the centrifugal force acting on the carrier module when conveyed,
- an angular acceleration ($\alpha$) acting on the carrier module when conveyed,
- a change of the angular acceleration acting on the carrier module when conveyed
- a jerk acting on the carrier module when conveyed,
- a change of the jerk acting on the carrier module when conveyed,
- a velocity of the carrier module when conveyed,
- a change of the velocity of the carrier module when conveyed,
- a payload to be carried by the carrier module when conveyed,
- a distance (d) between the starting point (P1) and the end point (P2) of the trajectory.

3. The method of claim 1 or 2, wherein the shape of the trajectory (T9) is determined, based on the function of the carrier angle, within an optimization.

4. The method of claim 3, wherein a tuning parameter of the optimization comprises distance between the starting point and the end point of the trajectory.

5. The method of any one of the preceding claims, wherein the trajectory comprises at least two segments (T1, T2, T3) connected to each other, and wherein the boundary conditions further comprise a pre-defined shape, preferably, a constant radius, of one (T2) of said at least two segments.

6. The method of claim 5, wherein the trajectory comprises at least three segments connected to each other, and wherein said segments having a pre-defined shape is enclosed by at two of said at least three segments.

7. The method of any one of the preceding claims, wherein said pre-defined angle ($\theta$) of the trajectory between the starting point and the end point is between 170° and 190°, preferably, 180°.

8. The method of any one of the preceding claims, wherein the boundary conditions further comprise that the trajectory is to be entered by the carrier module, at the starting point, in a straight movement, and/or that the trajectory is to be left by the carrier module, at the end point, in a straight movement.

9. The method of any one of the preceding claims, wherein determining the function of the carrier angle over time comprises:

Determining, based on the boundary conditions, a function of a carrier angular acceleration over time, when the carrier module is conveyed;
Determining, based on the function of a carrier angular acceleration over time, a function of a carrier angular velocity over time, when the carrier module is conveyed; and
Determining, based on the function of a carrier angular velocity over time, the function of the carrier angle over time.

10. A method of manufacturing one or multiple track modules, based on information (642) about a geometry of said one or each of said multiple track modules, wherein said information about the geometry is obtained by means the method of any one of the preceding claims.

11. A system comprising one or multiple track modules, wherein said one or each of said multiple track modules (102.1, 102.2, 102.3, 102.4) comprises a conveying path and is configured to receive a carrier module (150, 350), the carrier module (150, 350) to be conveyed within said one track module or within said multiple track modules when connected to each other, along a trajectory,

wherein the trajectory (T) is defined by the conveying path or the conveying paths being connected to each other, wherein the trajectory (T) comprises a starting point and an end point, and wherein the trajectory is, at least in part, curved, wherein a curvature of the trajectory, from the starting point to the end point, continuously increases until an intermediate point and then continuously decreases from that intermediate point or another intermediate point.

12. The system of claim 11, wherein a geometry of said one or each of said multiple track modules corresponds to the geometry obtained by means the method of any one of claims 1 to 9.

13. A system comprising one or multiple track modules (102.1, 102.2, 102.3, 102.4),
wherein a geometry of said one or each of said multiple track modules corresponds to the geometry obtained by means the method of any one of claims 1 to 9.

14. A linear motor conveying system (100), comprising the system of any one of claims 11 to 13, and one or more carrier modules (150, 350) to be guided in the one or more track modules,
wherein the one or each of the more carrier modules (150, 350) is received or receivable in the one or each of the more track modules (102.1, 102.2, 102.3, 102.4).

15. The linear motor conveying system (100) of claim 14, further comprising a controlling system (190) for controlling the linear motor conveying system to move the one or each of the more carrier modules within the one or more track modules.

**Fig. 1**

**Fig. 2**

# Fig. 3a

301

350

331.1

331.2

340.1

311

310

340.2

313

312

z

y

x

**Fig. 3b**

**Fig. 3c**

# Fig. 4a

# Fig. 4b

# Fig. 5a

## Fig. 5b

# Fig. 6

Europäisches
Patentamt

European
Patent Office

Office européen
des brevets

# EUROPEAN SEARCH REPORT

Application Number

EP 23 19 3356

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Beckhoff: "Drive Technology – Rethought. XTS. eXtended Transport System", interempresas.net, 26 April 2012 (2012-04-26), pages 1-32, XP093064846, Retrieved from the Internet: URL:https://www.interempresas.net/FeriaVirtual/Catalogos_y_documentos/171630/XTS_Beckhoff_e.pdf [retrieved on 2023-07-18] | 1-9 | INV. G06F30/15 B65G54/02 ADD. G06F30/20 B65G23/23 |
| A | * the whole document * | 10 | |
| X | US 2022/027529 A1 (ZARUR ASHRAF [SE] ET AL) 27 January 2022 (2022-01-27) | 1-9 | |
| A | * abstract; claims 1-19; figures 1-54 * * page 25, paragraph [0221] – page 26, paragraph [0232] * * page 29, paragraph [0248]-[0251] * * page 31, paragraph [0263] * | 10 | |
| X | US 9 511 681 B2 (ROCKWELL AUTOMATION INC [US]) 6 December 2016 (2016-12-06) | 11-15 | TECHNICAL FIELDS SEARCHED (IPC) |
| A | * abstract; claims 1-20; figures 1A-1B,2,3A-3C,6-28 * * column 4, lines 9-43 * * column 4, line 53 – column 5, line 18 * * column 5, lines 31-58 * * column 6, lines 30-48 * * column 10, lines 19-63 * | 10 | G06F B65G |
| X | JP 2020 129854 A (FUJI CORP) 27 August 2020 (2020-08-27) | 11-15 | |
| A | * figures 1-13 * | 10 | |

The present search report has been drawn up for all claims

| Place of search | Date of completion of the search | Examiner |
|---|---|---|
| Munich | 14 February 2024 | Fernandez, Eva |

EPO FORM 1503 03.82 (P04C01)

## ANNEX TO THE EUROPEAN SEARCH REPORT
## ON EUROPEAN PATENT APPLICATION NO.

EP 23 19 3356

This annex lists the patent family members relating to the patent documents cited in the above-mentioned European search report.
The members are as contained in the European Patent Office EDP file on
The European Patent Office is in no way liable for these particulars which are merely given for the purpose of information.

14-02-2024

| Patent document cited in search report | | | Publication date | Patent family member(s) | | | Publication date |
|---|---|---|---|---|---|---|---|
| US 2022027529 | A1 | | 27-01-2022 | CN | 114036704 | A | 11-02-2022 |
| | | | | EP | 3944034 | A1 | 26-01-2022 |
| | | | | US | 2022027529 | A1 | 27-01-2022 |
| US 9511681 | B2 | | 06-12-2016 | EP | 2806547 | A1 | 26-11-2014 |
| | | | | EP | 3734816 | A1 | 04-11-2020 |
| | | | | US | 2014331888 | A1 | 13-11-2014 |
| | | | | US | 2017081135 | A1 | 23-03-2017 |
| | | | | US | 2019177097 | A1 | 13-06-2019 |
| | | | | US | 2019185276 | A1 | 20-06-2019 |
| JP 2020129854 | A | | 27-08-2020 | JP | 7313836 | B2 | 25-07-2023 |
| | | | | JP | 2020129854 | A | 27-08-2020 |

EPO FORM P0459

For more details about this annex : see Official Journal of the European Patent Office, No. 12/82